Europäisches Patentamt

European Patent Office

Office européen des brevets

(11) Veröffentlichungsnummer: **0 003 718**
A1

# (12) EUROPÄISCHE PATENTANMELDUNG

(21) Anmeldenummer: 79810011.1

(22) Anmeldetag: 29.01.79

(51) Int. Cl.²: **B 29 D 3/02**, C 08 J 5/24, C 08 L 61/06, B 32 B 17/06, D 04 H 1/48

(30) Priorität: 07.02.78 CH 1323/78

(43) Veröffentlichungstag der Anmeldung: 22.08.79 Patentblatt 79/17

(84) Benannte Vertragsstaaten: BE DE FR GB IT

(71) Anmelder: Hug Interlizenz AG, alte Zürcherstrasse 49, CH-8903 Birmensdorf (CH)

(72) Erfinder: Der Erfinder hat auf seine Nennung verzichtet

(74) Vertreter: Fiedler, Otto Karl, Dipl.-Ing., Rheinhöhe 9, D-7891 Küssaberg 1 (DE)

(54) Glasfaserverstärkte Kunststoffe und Verfahren zu deren Herstellung.

㉗ Glasfasergewebe/Glasfasermatten-Komplexe werden mit einem Phenolharz imprägniert, getrocknet, aufeinandergestapelt und unter Druck bei erhöhter Temperatur behandelt. Es werden Schichtmaterialien mit technisch interessanten mechanischen, chemischen, elektrischen und thermischen Eigenschaften erhalten.

EP 0 003 718 A1

## Glasfaserverstärkte Kunststoffe

Die vorliegende Erfindung betrifft neue geschichtete, verstärkte Kunststoffe aus Glasfasern und thermohärtbaren Phenolen, ihre Herstellung und ihre Verwendung.

Seit vielen Jahren stellt man geschichtete, verstärkte Kunststoffe aus Glasfasergeweben und thermohärtbaren Harzen, wie z.B. Epoxidharzen, ungesättigten Polyestern, Phenolen, Aminoplasten, Polyimiden, Siliconen, Polyamid-Imiden usw., her. Die Herstellung erfolgt nach dem sogenannten "Trockenverfahren", wobei das Glasfasergewebe in eine Harzlösung eingetaucht und dann zur Erlangung eines trockenen, vorimprägnierten Materials in einem Tunnelofen getrocknet wird. Dieses vorimprägnierte Material wird in Blätter bzw. Folien zerschnitten und in einer geheizten Presse aufgestapelt, wo sie unter der Einwirkung von Temperatur und Druck einen einheitlichen Block ergeben.

Bekannt sind ebenfalls auf nassem Weg hergestellte geschichtete, verstärkte Kunststoffe aus Glasfasermatten und thermohärtbaren Harzen. Die Glasfasermatte besteht aus Glasfasern, die mit Hilfe eines mit dem verwendeten Harz verträglichen Bindemittels zusammengehalten werden. Die mechanischen Eigenschaften der Glasfasermatte und die Reaktionsfähigkeit des Bindemittels mit dem Harz erlauben jedoch kein kontinuierliches maschinelles Beschichten der Glasfasermatten samt teilweisem Trocknen. Das Herstellungsverfahren besteht darin, dass man das Harz auf jede einzelne blattförmige Glasfasermatte aufgiesst und darauf verteilt. Zur Herstellung des Schichtmaterials werden die aufeinandergestapelten Blätter nun direkt in die Presse eingebracht.
Dieses Verfahren setzt flüssige Harze voraus, die bei der zur
Anwendung gelangenden Temperatur nur wenig reaktionsfähig sind
und kein Lösungsmittel enthalten. Heute kommen auf Grund dieser
Voraussetzungen Polyester- und Epoxid-Harze zum Einsatz.

Geschichtete verstärkte Kunststoffe werden ebenfalls durch
gleichzeitiges Einspritzen von Glasfasern und Harz in eine
Form oder auf eine andere Unterlage erhalten. Mit Polyesterharzen stellt man auch Fasermischungen her, sogenannte Premix oder
Compounds oder Prepegs, die in einer Form zu Platten oder anderen Formen verarbeitet werden.

Die Eigenschaften dieser Schichtmaterialien variieren sehr
stark. Sie hängen von der Form des Glasfaserverbandes, vom
Glasgehalt, von der Art des verwendeten Harzes und vom zur Anwendung gelangenden Herstellungsverfahren ab. Die aus Geweben
auf nassem Weg erhaltenen Schichtmaterialien weisen sehr gute
mechanische, elektrische und chemische Eigenschaften auf, nur
sind im allgemeinen die betreffenden Herstellungskosten sehr
hoch.

Die Herstellungskosten der aus nicht gewobenen Glasfasern hergestellten Schichtmaterialien sind weniger hoch. Im Gesamten sind aber die Eigenschaften dieser Materialien weniger gut als diejenigen von Schichtmaterialien, die mit Hilfe von Geweben hergestellt worden sind.

Die vorliegende Erfindung bezieht sich nun auf die Herstellung von geschichteten, verstärkten Kunststoffmaterialien, welche die Vorteile der Herstellungsverfahren auf trockenem, sowie auch auf nassem Weg aufweist, ohne jedoch deren Nachteile aufzuzeigen.

Die Schichtmaterialien gemäss vorliegender Erfindung werden durch Ueberziehen eines Glasfaserkomplexes mit einem Phenolharz erhalten, wobei dieser Glasfaserkomplex ein Rovinggewebe umfasst, auf dem eine Glasfasermatte fixiert ist.

Das Ueberziehen mit der Harzschicht kann in einer Wanne, das nachfolgende Auswringen zwischen zwei Zylindern und das Trocknen in einem Tunnelofen bei Temperaturen von 80 bis 160$^{o}$C erfolgen.

Das erhaltene vorimprägnierte Material wird in Blätter bzw. Folien zerschnitten. Diese werden aufgestapelt und der Stapel wird in eine heizbare Presse oder in eine Form gebracht.

Die zur Anwendung gelangenden Harze sind Phenol-Harze, und zwar gelöst in Wasser, in einem alkoholischen Lösungsmittel oder in organischen Lösungsmittelgemischen. Diese Harze entstehen durch Reaktion eines Aldehyds wie z.B. des Formaldehyds mit einer phenolisch reagierenden Verbindung. Verwendet werden können selbsthärtende Harze wie Resole oder auch Harze, bei denen die Härtung durch Zusatzstoffe wie Hexamethylentetramin oder Säuren (Typ Novolak) sichergestellt wird.

Der Glasfaserkomplex kann eine Beschichtung von 50 - 2000 gr/m$^2$ aufweisen, bei einem Flächengewicht des Gewebes von 20 - 1500 gr und einem Flächengewicht der Glasfasermatte von 50 - 1500 gr/m$^2$.

Der Bindefaden zwischen der Glasfasermatte und dem Glasfasergewebe soll den guten Eigenschaften des Ganzen nicht schaden. Er besteht entweder aus Glas oder aus synthetischen Fasern oder aus Naturfasern.

Die Oelung der Fasern und deren Ausrüstung sind mit Phenolharzen (Aminosilane, Epoxisilane, usw.) kompatibel.

Einer der Vorteile des erfindungsgemässen Verfahrens liegt darin, dass die Verwendung von Zwischenbindemitteln, oft Polyester, vermieden wird. Solche Zwischenbindemittel verschlechtern die charakteristischen Eigenschaften der betreffenden Schichtmaterialien.

Die Phenolharze weisen ausgezeichnete mechanische, thermische, elektrische und chemische Eigenschaften auf. Den aus Glasfasergeweben hergestellten Schichtmaterialien sind dabei nicht alle erwähnten Eigenschaften gesamthaft zu eigen, da die Haftfestigkeit zwischen den Schichten des Schichtmaterials sehr schwach ist und das Produkt zur Entschichtung neigt. Aus diesem Grund haben diese Materialien bei der industriellen Anwendung keinen grossen Erfolg gehabt.

Die Verwendung des oben erwähnten Glaskomplexes gestattet es nun, diesen Nachteilen zu begegnen.Auf Grund des während der Hitzebehandlung erfolgenden Drucks dringen die aus der Glasfasermatte stammenden Glasfasern in das Gewebe ein und sorgen für entsprechende transversale Bindungen, womit der Neigung zur Entschichtung begegnet wird. So hat z.B. ein mit einem Glasfasergewebe verstärkter, geschichteter phenolischer Kunststoff bei 20°C eine Biegefestigkeit zwischen 10 und 20 da N/mm$^2$, während ein entsprechendes Schichtmaterial, das unter Verwendung des gleichen Harzes und eines Glasfasergewebe/Glasfasermatte-Komplexes gemäss vorliegender Erfindung hergestellt wurde, eine Biegefestigkeit von 30 - 60 da N/mm$^2$ aufweist.

Aus der unten wiedergegebenen Tabelle sind weitere Eigenschaften der neuen geschichteten Kunststoffe gemäss vorliegender Erfindung ersichtlich, wobei mit den Eigenschaften entsprechender Schichtmaterialien verglichen wird, die mit Hilfe von Glas-

fasergeweben hergestellt wurden:

|  | mit Glasfasergewebe geschichtet | mit Glasfasergewebe/-Matte geschichtet |
| --- | --- | --- |
| Elastizitätsmodul bei 20°C | 1000 - 2000 da N/mm$^2$ | 2500 - 3000 da N/mm$^2$ |
| Wasserabsorption nach Eintauchen in Wasser während 24 Stunden | 1 - 2% | 0,3 - 0,5% |
| Durchschlagfestigkeit (transversale) | 5 - 10 KV/mm | > 20 KV/mm |
| Biegefestigkeit bei 130°C | 5 - 10 da N/mm$^2$ | 20 - 30 daN/mm$^2$ |

Im Besonderen weisen die Schichtmaterialien gemäss vorliegender Erfindung die folgenden Eigenschaften auf:

- Biegefestigkeit von 30 - 60 da N/mm$^2$ bei 20°C

- Biegefestigkeitsverlust zwischen 20 - 130°C von < 50%

- Elastizitätsmodul bei 20°C von 2500 - 3000 da N/mm$^2$

- transversale dielektrische Durchschlagsfestigkeit von > 20 KV/mm

- Wasserabsorption nach 24 Std. von 0,3 - 0,5%

- transversale Durchschlagsfestigkeit in trockenem Zustand von ca. 4 x $10^{12} \Omega$/cm$^2$/cm

- Widerstand in trockenem Zustand ca. 9 x $10^{10} \Omega$

- Flammfestigkeit : VO gemäss UL94 (ohne dass toxische und korrodierende flüchtige Stoffe entstehen)

Gemäss dem erfindungsgemässen Verfahren ist es leicht möglich, das den Gehalt an Glasfasern und an Phenolharz betreffende Prozentverhältnis zu variieren. Die Phenolharze sind billiger als die Glasfasern. Ein hoher Gehalt an Phenolharz macht es also möglich, solche Schichtmaterialien in bezug auf bereits existierende Produkte preislich sehr konkurrenzfähig zu gestalten.

Im Fall einer Feuersbrunst stellt ausserdem die Verwendung von leicht brennbaren organischen Produkten wie Polyester- und Epoxid-Harze eine grosse Gefahr dar. Dies trifft nun auf die neuen Schichtmaterialien nicht zu, da sie in bezug auf Selbstlöschen eines Brandes den amerikanischen Normen UL 94 entsprechen.

Hinzu kommt, dass diese letztere Eigenschaft erreicht wird, ohne dass feuerfestmachende halogenierte, phosphatierte oder andere Produkte hinzugefügt werden, die sehr gefährlich sind, weil sie bei höheren Temperaturen korrodierende und zum Ersticken führende flüchtige Produkte abgeben. Die Phenolharze verbrennen sehr schlecht unter Bildung von Kohlenstoff und Abgabe von Wasser und Kohlendioxidgas.

Dank der einfachen Herstellungsweise, die mit den bekannten technischen Mitteln ausführbar ist und dank den ihnen innewohnenden unerreicht guten Eigenschaften können die neuen Schichtmaterialien gemäss vorliegender Erfindung als wesentliche mechanische, chemische, elektrische und thermische Bau- bzw. Arbeitselemente eine weite industrielle Verwendbarkeit finden.

So können die erfindungsgemässen Schichtmaterialien z.B. in Form
von Platten als elektrische Isolierstoffe, durch Aufrollen,
Wickeln oder in einer Form erzeugte Formkörper in der gesamten
Industrie, in Form von grossformatigen Platten oder sonstwie
geformt als Brandschutzelemente in der Bauindustrie und als
ein- oder beidseitig mit Kupfer überzogene Elemente zur Herstellung von gedruckten Schaltungen Verwendung finden.

Die folgenden Beispiele sollen das Wesen der vorliegenden Erfindung veranschaulichen, ohne dieses jedoch in irgendeiner
Weise zu beschränken.

## Beispiel 1

Auf einer horizontalen Maschine wird eine Glasfasermischung von 1200 g/m², die aus einem Rovinggewebe von 300 gr/m² und einer Glasfasermatte von 900 g/m² besteht, mit einem Phenolharz des Resoltyps überzogen bzw. imprägniert, das die folgenden charakteristischen Daten aufweist:

- Viskosität bei 20°C = 300 cp
- Trockenextrakt = 55%
- Härtungszeit bei 150°C = 100 sec.
- Lösungsmittel : Methylalkohol

Getrocknet wird das Harz mit Hilfe eines Tunnelofens von 15 m Länge, wobei die Temperatur von 80°C beim Eintritt sich auf 120°C beim Austritt erhöht.

Das erhaltene vorimprägnierte Material setzt nach einer Verweilzeit von 10 min bei 150°C 2,5% an flüchtigen Substanzen frei. Der Flow-Test ergibt, bei 150°C gemessen, einen Wert von 2%.

Nach Zerschneiden in Blätter bzw. Folien vom Format 1000 x 1300 mm und Aufstapeln in einer auf 150°C geheizten Presse, erhält man nach 30 min Verweilzeit bei einem Druck von 10 kg/mm² ein Schichtmaterial, das 4 mm dick ist und die folgenden charakteristischen Daten aufweist:

- Glasgehalt :  66%

- Dichte :     1,85

- Biegefestigkeit bei 20°C : 56 da N/mm$^2$

- Elastizitätsmodul : 2770 da N/mm$^2$

- Wasserabsorption nach 24 Std.:  0,33 %

- Feuerfestigkeit:  VO gemäss UL 94

## Beispiel 2

Das Phenolharz des Resol-Typs wird durch ein Novolak-Harz ersetzt (Härtung: 10% Hexamethylentetramin), ansonst verfährt man gemäss Beispiel 1. Man erhält ein Schichtmaterial mit den folgenden charakteristischen Daten:

- Glasgehalt : 60%

- Dichte : 1,62

- Biegefestigkeit bei 20°C : 40 da N/mm$^2$

-         "           "  130°C: 25 da N/mm$^2$

- Wasserabsorption nach 24 Std. : 0,35%

- Durchschlagfestigkeit (trocken) :  20 KV/mm

- transversaler Widerstand (trocken) : 4 x 10$^{12}$ $\Omega$/cm$^2$/cm

     "               "        (nach Eintauchen während 24 Stunden
                              in Wasser):7 x 10$^{11}$ $\Omega$/cm$^2$/cm

- Isolationswiderstand (trocken) : 9 x 10$^{10}$ $\Omega$

                      (nach Eintauchen während 24 Std.
                       in Wasser): 2,5 x 10$^9$ $\Omega$

### Beispiel 3

Es lassen sich ebenfalls thermostabile Phenolharze verwenden, die dem Schichtmaterial eine schwache Thermoplastizität und für 5000 Std. bei 200 - 250°C eine hohe Festigkeit verleihen. Dieses Schichtmaterial kann als ablationsbeständiges Produkt für Isolationsstoffe, die bei sehr hohen Temperaturen (800 - 1000°C) eingesetzt werden, Verwendung finden.

### Beispiel 4

Das gemäss Beispiel 1 erhaltene vorimprägnierte Produkt wird heiss zusammengedrückt, wobei auf jeder Seite ein Blatt aufgebracht ist, das aus elektrolytischem Kupfer besteht und mit einem geeigneten Klebemittel beschichtet ist. Nach einer Behandlungszeit von 1 Std. bei 150°C und einem Druck von 20 bar erhält man einen verkupferten, isolierenden Träger, dessen Eigenschaften den Normen entspricht, die für gedruckte Schaltungen gelten.

- Dicke: 1,6 mm
- Widerstand gegenüber einem Zinnbad: ausgezeichnet
- Kraft zum Abreissen der Kupferschicht: $>$ 6 da N/cm

### Beispiel 5

Mit Hilfe der Ausgangsstoffe gemäss Beispiel 1 wird ein vorimprägniertes Produkt hergestellt, das weniger getrocknet worden ist als das im Beispiel 1 hergestellte Material und damit sehr biegsam ist. Diese Plastizität erlaubt es durch Pressformen geformte Stücke gemäss derjenigen Technik herzustellen, die für thermohärtbare Harze verwendet wird. Unter den in Beispiel 1 angegebenen Druck- und Temperaturbedingungen werden geformte Gegenstände erhalten, deren mechanische, elektrische und thermische Eigenschaften denjenigen entsprechen, die die als Platte geformten Schichtmaterialien aufweisen.

## Beispiel 6

Das vorimprägnierte Material gemäss Beispiel 1 wird in einer Presse, die es erlaubt, grossformatige Stücke herzustellen, unter Druck gesetzt. Es werden so Füllungen hergestellt, die im Häuserbau Verwendung finden können und die den Sicherheitsbestimmungen betreffend Brandschutz entsprechen. Das erhaltene Schichtmaterial hält ohne zu schmelzen, ohne Weiterverbreitung der Flamme und ohne Freisetzung von gefährlichen oder korrodierenden flüchtigen Stoffen hohe Temperaturen aus. Dieses Schichtmaterial ersetzt mit sehr gutem Ergebnis das bereits bekannte Produkt, das durch Imprägnierung mit wässrigen Phenolharzen erhalten wird.

0003718

Hug Interlizenz AG                    8903 <u>Birmensdorf</u> (Schweiz)

P A T E N T A N S P R U E C H E

1. Glasfaserverstärkte Kunststoffe, dadurch gekennzeichnet, dass sie Schichten enthalten, die aus einem Glasfasergewebe, einer Glasfasermatte und Phenolharz bestehen.

2. Glasfaserverstärkte Kunststoffe gemäss Patentanspruch 1, dadurch gekennzeichnet, dass die Schicht ein Phenolharz des Resol- oder des Novolak-Typs oder eine Mischung der beiden enthält.

3. Glasfaserverstärkte Kunststoffe gemäss den Patentansprüchen 1 und 2, dadurch gekennzeichnet, dass die Glasfasergewebe ein  Flächengewicht     von 20 - 1500 gr/m$^2$ und die Glasfasermatten ein solches von 50 - 1500 gr/m$^2$ aufweisen.

4. Glasfaserverstärkte Kunststoffe, dadurch gekennzeichnet, dass sie eine

   - Biegefestigkeit von 30 - 60 da N/mm$^2$ bei 20$^o$C,

   - Biegefestigkeitsverlust zwischen 20$^o$ - 130$^o$C von < 50%

   - Elastizitätsmodul bei 20$^o$C von 2500 - 3000 da N/mm$^2$

   - transversale dielektrische Durchschlagsfestigkeit von > 20 KV/mm

   - Wasserabsorption nach 24 Std. von 0,3 - 0,5%

0003718

- transversale Durchschlagsfestigkeit in trockenem Zustand von ca. $4 \times 10^{12} \, \Omega/cm^2/cm$

- elektrischer Widerstand (trocken): ca. $9 \times 10^{10} \, \Omega$

- Flammfestigkeit VO gemäss UL 94 aufweisen.

5. Verfahren zur Herstellung eines glasfaserverstärkten Kunststoffes gemäss den Patentansprüchen 1 - 4, dadurch gekennzeichnet, dass man eine Glasfasergewebe/Glassfasermatte-Schichtung mit einem Phenolharz imprägniert, trocknet und das Ganze unter Druck bei erhöhter Temperatur behandelt.

6. Verfahren zur Herstellung eines glasfaserverstärkten Kunststoffes gemäss Patentanspruch 5, dadurch gekennzeichnet, dass das Glasfasergewebe und die Glasfasermatte mittels Fasern miteinander verbunden sind, die mit den verwendeten Phenolharzen verträglich sind, vorteilhafterweise mit aus der Glasfasermatte stammenden Glasfasern.

7. Verfahren zur Herstellung eines glasfaserverstärkten Kunststoffes gemäss Patentanspruch 5, dadurch gekennzeichnet, dass das Ganze unter einem Druck von $1 - 100$ kg/mm$^2$ bei $100 - 160^{\circ}$C behandelt wird.

0003718

8. Verfahren zur Herstellung eines glasfaserverstärkten Kunststoffs gemäss Patentanspruch 5, dadurch gekennzeichnet, dass das Trocknen bei 80 - 160$^O$ erfolgt.

9. Verwendung von glasfaserverstärkten Kunststoffen gemäss den Patentansprüchen 1 - 4 in plattenförmiger Form als elektrische Isolierstoffe.

10. Verwendung von glasfaserverstärkten Kunststoffen gemäss den Patentansprüchen 1 - 4 als Wickel oder als in einer Form erzeugter Formkörper.

11. Verwendung von glasfaserverstärkten Kunststoffen als Brandschutzelemente in der Bauindustrie.

12. Verwendung von glasfaserverstärkten Kunststoffen als ein- oder beidseitig mit Kupfer überzogene Trägerelemente zur Herstellung von gedruckten Schaltungen.

**Europäisches Patentamt**

# EUROPÄISCHER RECHERCHENBERICHT

| | EINSCHLÄGIGE DOKUMENTE | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| X | FR - A - 2 224 293 (DROUET DIAMOND)<br><br>* Seite 1, Zeilen 9,10; Seite 2, Zeilen 34-38; Seite 4, Zeile 19 - Seite 5, Zeile 10; Seite 5, Zeile 27 *<br><br>-- | 1,3,5, 7,9,12 | B 29 D 3/02<br>C 08 J 5/24<br>C 08 L 61/06<br>B 32 B 17/06<br>D 04 H 1/48 |
| X | BE - A - 626 701 (N.V. SYNCOGLAS)<br><br>* Seiten 1-3 *<br><br>-- | 1,3,5 | |
| X | BE - A - 632 138 (N.V. SYNCOGLAS)<br><br>* Seite 2, Spalte 2; Ansprüche *<br><br>-- | 1,3,5, 6 | **RECHERCHIERTE SACHGEBIETE (Int. Cl.²)**<br><br>B 29 D 3/02<br>B 32 B<br>C 08 J 5/24<br>C 08 L 61/06<br>D 04 H 13/00<br>1/48<br>5/02<br>5/04 |
| | FR - A - 1 159 906 (S.A. DES PNEUMATIQUES DUNLOP)<br><br>* Seiten 1,2 *<br><br>-- | 1,2 | |
| | US - A - 3 111 569 (D. RUBENSTEIN)<br><br>* Spalte 6, Zeilen 36-51,68; Spalte 8, Zeile 18; Spalte 10, Zeilen 6-10; Spalte 13, Zeilen 48-57; Spalte 32, Zeile 34; Spalte 37, Zeilen 51-55 *<br><br>-- | 1,2,5, 11 | |
| | FR - A - 2 218 999 (J. BROCHIER & FILS)<br><br>* Seite 1, Zeile 3; Seite 1, Zeile 35 - Seite 2, Zeile 14; Seite 2, Zeile 21; Beispiel 2 *<br><br>-- | 1,3,5, 6 | **KATEGORIE DER GENANNTEN DOKUMENTE**<br><br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument |
| | DE - B - 1 560 896 (MOELNLYCHE AB)<br>./. | 1,5,6 | |

Der vorliegende Recherchenbericht wurde für alle Patentansprüche erstellt.

&: Mitglied der gleichen Patentfamilie, übereinstimmendes Dokument

| Recherchenort | Abschlußdatum der Recherche | Prüfer |
|---|---|---|
| Den Haag | 14-05-1979 | VAN BELLEGHEM |

EPA form 1503.1 06.78

| EINSCHLÄGIGE DOKUMENTE | | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| | * Spalte 1, Zeile 50 - Spalte 3, Zeile 2 * | | |
| | -- | | |
| | US - A - 3 472 730 (R.A. FRIGSTAD) | 2,10 | |
| | * Spalte 2, Zeile 12; Beispiel 1 * | | |
| | - | | |
| | US - A - 3 691 000 (IL KALNIN) | 1,2 | |
| | * Spalte 3, Zeile 50; Spalte 8, Zeilen 13-15; Spalte 9, Zeilen 5-10; Figuren * | | **RECHERCHIERTE SACHGEBIETE (Int. Cl.²)** |
| | -- | | |
| | FR - A - 1 423 268 (THE CINCINNATI MILLING MACH) | 1,2,5 | |
| | * Seite 1, Zeilen 1-6; Seite 2; Figuren * | | |
| | -- | | |
| | FR - A - 2 223 188 (MICAFIL AG) | 1,5,9 | |
| | * Seite 3; Seite 5, Zeilen 22-31; Seite 6, Zeilen 7,20-40 * | | |
| | -- | | |
| | FR - A - 2 313 188 (SHELL INT. RESEARCH MAATSCHAPPIJ) | 2,4,12 | |
| | * Seite 2, Zeilen 5-21; Seite 4, Zeilen 15-18; Seite 7, Zeilen 18-24; Seite 9 * | | |
| | -- | | |
| | FR - A - 2 349 353 (HUYCK CORP.) | 1 | |
| | * Seite 3, Zeile 22; Seite 6, Zeilen 8-14,26-29; Seite 9, Zeilen 3-8 * | | |
| | -- ./. | | |

| EINSCHLÄGIGE DOKUMENTE | | | KLASSIFIKATION DER ANMELDUNG (Int.Cl.³) |
|---|---|---|---|
| Kategorie | Kennzeichnung des Dokuments mit Angabe, soweit erforderlich, der maßgeblichen Teile | betrifft Anspruch | |
| A | FR - A - 2 158 256 (FORMICA INT. LIM) | | |
| A | US - A - 3 506 531 (M. STANDER) | | |
| A | US - A - 2 746 049 (R.A. HUDSON) | | |
| A | DE - A - 2 622 206 (HENSEL W.) | | |
| A | GB - A - 862 545 (KIMBERLEY - CLARK CORP.) | | |
| | ---- | | **RECHERCHIERTE SACHGEBIETE (Int. Cl.³)** |

EUROPÄISCHES PATENTAMT — **EUROPÄISCHER RECHERCHENBERICHT**

0003718

Europäisches Patentamt

EPA Form 1503.2 06.78